(19) Europäisches Patentamt
European Patent Office
Office européen des brevets

(11) **EP 3 129 799 B1**

(12) **EUROPÄISCHE PATENTSCHRIFT**

(45) Veröffentlichungstag und Bekanntmachung des Hinweises auf die Patenterteilung:
**25.07.2018  Patentblatt 2018/30**

(21) Anmeldenummer: **15707640.7**

(22) Anmeldetag: **03.03.2015**

(51) Int Cl.:
*H02M 3/157* (2006.01)     *H02M 3/158* (2006.01)
*G05B 13/02* (2006.01)     *G05B 13/04* (2006.01)
*G01R 31/36* (2006.01)

(86) Internationale Anmeldenummer:
**PCT/EP2015/054415**

(87) Internationale Veröffentlichungsnummer:
**WO 2015/154918 (15.10.2015 Gazette 2015/41)**

(54) **VERFAHREN UND REGLER ZUR MODELLPRÄDIKTIVEN REGELUNG EINES MEHRPHASIGEN DC/DC-WANDLERS**

METHOD AND CONTROLLER FOR THE MODEL-PREDICTIVE CONTROL OF A MULTI-PHASE DC/DC-CONVERTER

MÉTHODE ET CONTRÔLEUR POUR LE CONTRÔLE PRÉDICTIVE D'UN MULTIPHASE DC / DC-CONVERTISSEUR, BASÉ SUR UN MODÈLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.04.2014   AT 502652014**

(43) Veröffentlichungstag der Anmeldung:
**15.02.2017   Patentblatt 2017/07**

(73) Patentinhaber: **AVL List GmbH**
**8020 Graz (AT)**

(72) Erfinder:
• BATLINER, Martin
  FL-9492 Eschen (LI)
• KÖNIG, Oliver
  A-8042 Graz (AT)
• JAKUBEK, Stefan
  A-1230 Wien (AT)
• PROCHART, Günter
  A-8042 Graz (AT)

(74) Vertreter: **Patentanwälte Pinter & Weiss OG**
**Prinz-Eugen-Straße 70**
**1040 Wien (AT)**

(56) Entgegenhaltungen:
WO-A1-2014/006200     US-A1- 2007 114 985
US-A1- 2012 183 056     US-A1- 2014 058 787

• OLIVER KONIG ET AL: "Model predictive control of a battery emulator for testing of hybrid and electric powertrains", 2011 IEEE VEHICLE POWER AND PROPULSION CONFERENCE (VPPC 2011) : CHICAGO, ILLINOIS, USA, 6 - 9 SEPTEMBER 2011, IEEE, PISCATAWAY, NJ, 6. September 2011 (2011-09-06), Seiten 1-6, XP031974964, DOI: 10.1109/VPPC.2011.6043174 ISBN: 978-1-61284-248-6

**Beschreibung**

Die gegenständliche Erfindung betrifft ein Verfahren zur modellprädiktiven Regelung und einen modellprädiktiven Regler eines mehrphasigen DC/DC-Wandlers mit einer Halbbrücke mit zwei Schaltern für jeden Strang des mehrphasigen DC/DC-Wandlers, wobei die Schalter zur Erzeugung einer gewünschten Ausgangsgröße von einer Steuereinheit angesteuert werden.

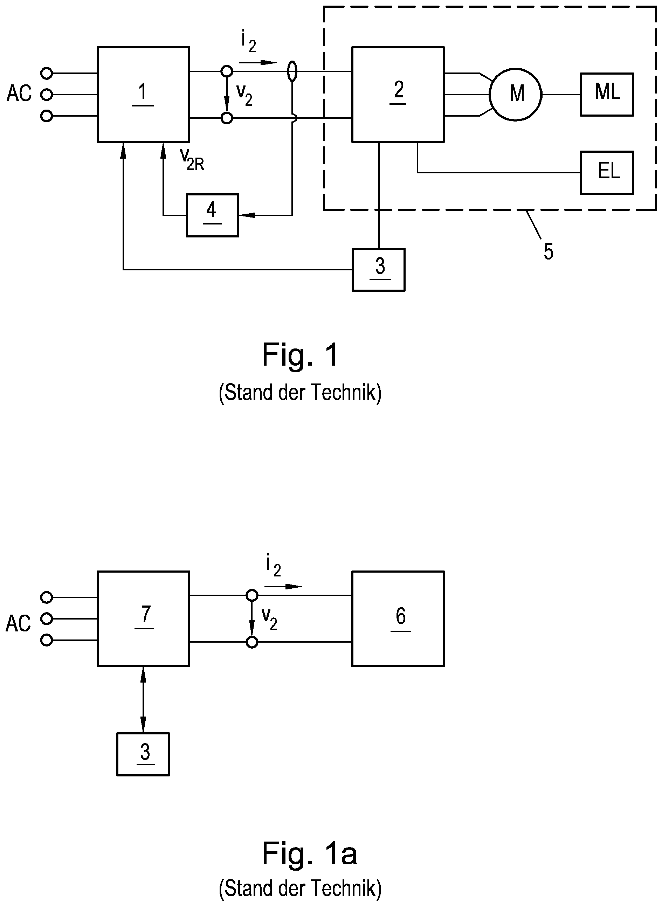

Ein Batterieemulator dient bekanntermaßen dazu, das Verhalten einer elektrischen Batterie nachzubilden. Solche Batterieemulatoren 1 werden z.B. bei der Entwicklung oder beim Testen von Antriebssträngen von Elektrofahrzeugen oder Hybridfahrzeugen oder für die Entwicklung von elektrischen Energiespeichern solcher Fahrzeuge benötigt, wie in Fig.1 angedeutet. Ein Batterieemulator 1 erzeugt in der Regel eine DC-Ausgangsspannung $v_2$ in Abhängigkeit von einem Laststrom $i_2$. Dazu wird der Laststrom $i_2$ gemessen und einem Batteriemodell 4 zugeführt, das aus dem Laststrom $i_2$ eine Referenz-Ausgangsspannung $v_{2R}$ berechnet, die dann vom Batterieemulator 1 an dessen DC-Spannungsausgang erzeugt wird. Am Batterieemulator 1 ist eine beliebige, reale elektrische Last 5 angeschlossen. Z.B. in Fig.1 gebildet aus einem Inverter 2, der einen Elektromotor M antreibt, der wiederum eine mechanische Last ML (z.B. ein Fahrzeug) antreibt. Am Inverter 2 können auch elektrische Lasten EL angeschlossen sein, z.B. elektrische Komponenten eines Fahrzeugs (beispielsweise eine Klimaanlage, Soundsystem, Lichtanlage, etc.). Der Batterieemulator 1 und die Last 5 bzw. ein Inverter 5 der Last 5 können von einer Steuereinheit 3, z.B. eine ECU des Fahrzeugs, gesteuert werden.

Ein Batterietester 7 dient bekanntermaßen dazu, eine reale elektrische Batterie 6 durch eine bestimmte Last, in Form eines DC-Laststromes $i_2$, zu belasten, wie in Fig.1 a dargestellt. Dabei stellt sich je nach Zustand der Batterie 6 (SoC, SoH) eine bestimmte DC-Ausgangsspannung $v_2$ ein, die gemessen werden kann. Zum Testen einer Batterie 6, z.B. im Rahmen der Batterieentwicklung, werden mit der Batterie 6 vorgegebene Prüfläufe, in Form eines vorgegebenen zeitlichen Verlaufs des DC-Laststromes $i_2$, durchgeführt. Der Batterietester 7 kann hierzu von einer Steuereinheit 3 gesteuert werden.

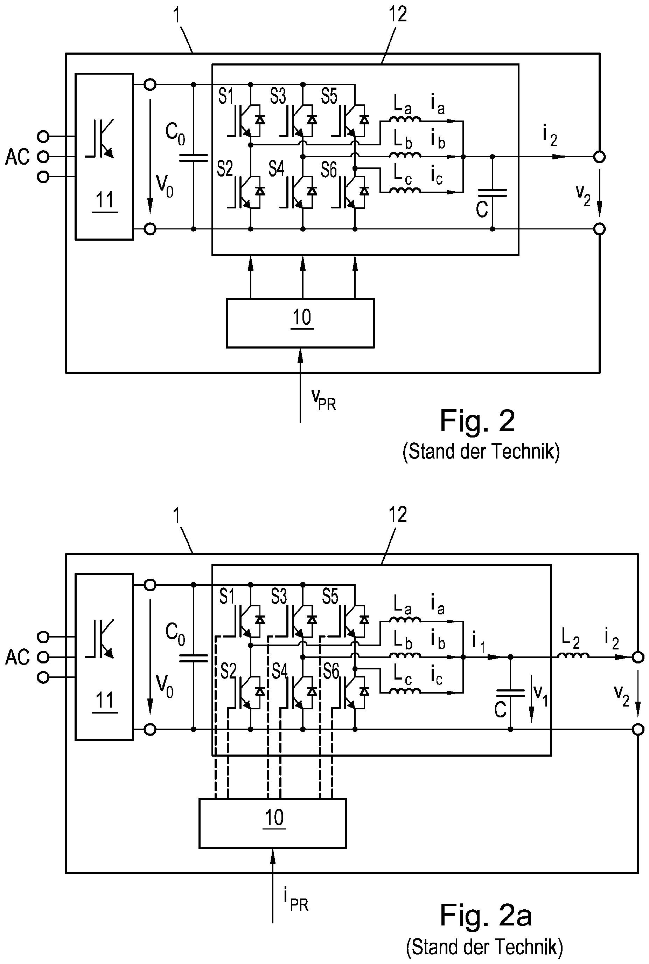

Im Batterieemulator 1 oder Batterietester 7 ist dazu typischerweise Leistungselektronik in Form eines DC/DC-Wandlers implementiert, der die benötige Ausgangsspannung $v_2$ (Batterieemulator 1) oder den benötigten Ausgangsstrom $i_2$ (Batterietester 7) erzeugt und zur Verfügung stellt. Der Batterieemulator 1 oder der Batterietester 7 kann dazu von einer, in der Regel eine 3-Phasen, Wechselspannungsquelle AC, die intern gleichgerichtet wird, oder von einer Gleichspannungsquelle versorgt werden. Ein solcher Batterieemulator 1 ist beispielhaft in Fig.2 dargestellt. Bei einem Batterietester 7 kann ausgangsseitig noch eine zusätzliche Drossel $L_2$ angeordnet sein, ansonsten stimmen die Schaltungen überein, wie in Fig.2a dargestellt. Eingangsseitig wird die dreiphasige Wechselspannung AC in einem Gleichrichter 11 und einem Glättungskondensator $C_0$ zu einer Gleichspannung $V_0$ gleichgerichtet. Daran angeschlossen sind ein dreiphasiger DC/DC-Wandler 12 mit parallelen Halbbrücken und Drosseln $L_a$, $L_b$, $L_c$, die von jeweils einer Halbbrücke angesteuert werden, und ein ausgangsseitiger Glättungskondensator C bzw. eine weitere Drossel $L_2$ (bei einem Batterietester 7). Solche DC/DC-Wandler 12 sind hinlänglich bekannt, weshalb hier nicht näher darauf eingegangen wird. Die Schalter S1 ... S6 der Halbbrücken werden durch eine Steuereinheit 10 angesteuert, um die gewünschte Ausgangsspannung $v_2$ bzw. den gewünschten Ausgangsstrom $i_2$ einzustellen. In der Steuereinheit 10 ist in der Regel eine hinlänglich bekannte Pulsweitenmodulation (PWM) vorgesehen, um über das Tastverhältnis (duty cycle) der Schalter die Ausgangsspannung $v_2$ bzw. den gewünschten Ausgangsstrom $i_2$ einzustellen. Bei einer PWM werden die Schalter in jedem Abtastzeitpunkt, gegeben durch eine bestimmte Abtastrate, einmal geschaltet. Die Abtastrate ist damit abhängig von der zulässigen Häufigkeit, mit der die Schalter S1 ... S6, in der Regel Bipolartransistoren mit isolierter Gate-Elektrode (IGBT) oder Metall-Oxid-Halbleiter-Feldeffekttransistoren (MOSFET), geschaltet werden können. Die Häufigkeit mit der die Schalter geschalten werden können ist jedoch durch die beim Schalten entstehenden Schaltverluste begrenzt. Da die PWM bei jedem Abtastschritt schaltet, begrenzt diese Limitierung auch die Abtastrate und somit auch die Reglerbandbreite. Diese Beschränkung führt zu einer schlechten Dynamik der Regelung solcher Wandler 12, dahingehend, dass nur langsam auf Störungen oder transiente Schaltvorgänge der Last 5 reagiert werden kann. Eine Erhöhung der Abtastrate in Form einer Überabtastung ist zwar möglich, aber nur unter starken Einschränkungen, weshalb Überabtastung für die Regelung des DC/DC-Wandlers 12 keine praktische Relevanz hat. Das Verfahren aus O. König, et al. "Model Predictive Control of a Battery Emulator for Testing of Hybrid and Electric Powertrains", verwendet ein herkömmliches PWM-Verfahren mit einer Model Predictive Control. Auch die US 2007/0114985 A1 zeigt ein Optimierungsproblem eines DC/DC-Wandlers und geht von einer PWM aus. Die WO 2014/006200 A1 beschreibt einen modularen Konverter, der aus vielen Einzelkonvertern besteht und verwendet eine herkömmliche PWM mit einem Model Predictive Control (MPC) Verfahren.

Um diesen Nachteil einer PWM zu umgehen wurde bereits eine neue Regelstrategie, die sogenannte Finite Control Set Model Predictive Control (FCS-MPC) eingeführt. Bei dieser Regelstrategie werden die Schalter S1 ... S6 direkt angesteuert, weshalb auf eine PWM verzichtet werden kann. Damit kann auch die Abtastrate erhöht und die Dynamik der Regelung verbessert werden. Solche Verfahren zur Direktansteuerung der Schalter in leistungselektronischen Systemen sind nicht neu. Ein Überblick darüber kann z.B. in J. Rodriguez, et al., "State of the art of finite control set model predictive control in power electronics", Industrial Informatics, IEEE Transactions, 9(2):1003 - 1016, Mai 2013 gefunden werden. In der EP 2 528 225 B1 findet diese Regelstrategie z.B. Anwendung für die Regelung einer elektrischen Maschine.

FCS-MPC zeichnet sich durch die beschränkte Anzahl Möglichkeiten für die Stellgröße, das sogenannte finite control set, aus. Für die Schalter S1 ... S6 der Halbbrücken des DC/DC-Wandlers 12 in Fig.2 oder Fig.2a ergeben sich unter der notwendigen Voraussetzung, dass in jeder Halbbrücke nie beide Schalter gleichzeitig offen oder geschlossen sind 8 ($2^3$) mögliche Schalterstellungen, die das finite control set bilden. Verfahren der modellprädiktiven Regelung (model predictive control) basieren bekanntermaßen auf einem Optimierungsproblem in Form der Minimierung eines Gütefunktionals, auch Kostenfunktion genannt. Das Problem hierbei ist, dass in das Gütefunktional eine Schaltsequenz gemäß dem gewählten Prädiktionshorizont (also eine Vorausschau der zukünftigen Schalterstellungen) einfließt. Damit wächst das Optimierungsproblem aber exponentiell mit dem Prädiktionshorizont. Unter Prädiktionshorizont versteht man die Anzahl der Abtastschritte, die in die Zukunft geschaut wird. Bei 8 möglichen Schalterstellungen ergeben sich bei einem Prädiktionshorizont von 1 $8^1$=8 Möglichkeiten, für die die Kostenfunktion gelöst werden muss, um das Optimum dieser Möglichkeiten zu finden. Bei einem Prädiktionshorizont von 5 würden sich aber schon $8^5$=32.000 Lösungen ergeben und bei einem Prädiktionshorizont von 10 schon über eine Milliarde Lösungen. Für eine angestrebte Echtzeitregelung muss die Lösung des Optimierungsproblems aber in sehr kurzer Zeit gefunden werden. Wenn mit einer Abtastrate von z.B. 20kHz abgetastet wird, dann muss die Lösung innerhalb eines Abtastschrittes, also innerhalb von 50 $\mu$s, vorliegen. Selbst mit den derzeit verfügbaren sehr schnellen Prozessoren, lässt sich das ab einem gewissen Prädiktionshorizont nicht mehr bewerkstelligen. Für die Regelung von DC/DC-Wandlern mit FCS-MPC werden aber große Prädiktionshorizonte (>10) angestrebt, um ein unerwünschtes Überschwingen bei transienten Regelvorgängen, z.B. bei Lastsprüngen, zu reduzieren.

In der WO 2013/174967 A1 ist ein modellprädiktives Regelverfahren für einen Batterieemulator beschrieben und in der WO 2013/174972 A1 ein modellprädiktives Regelverfahren für einen Batterietester. Darin werden allgemein das Verfahren der modellprädiktiven Regelung erläutert und ein Verfahren angegeben, mit dem das Optimierungsproblem ausreichend schnell gelöst werden kann, um Abtastraten im kHz Bereich zu ermöglichen. Die Ansteuerung des DC/DC-Wandlers erfolgt hier aber wieder jeweils mittels einer PWM mit allen oben erläuterten Nachteilen, insbesondere der Begrenzung der Abtastrate.

Die gegenständliche Erfindung hat sich nun das Ziel gesetzt, ein einfach umsetzbares Verfahren zur modellprädiktiven Regelung eines DC/DC-Wandlers, und einen entsprechenden Regler, anzugeben, mit dem das Optimierungsproblem auch bei großen Prädiktionshorizonten ausreichend schnell gelöst werden kann.

Diese Aufgabe wird erfindungsgemäß nach den Merkmalen des Verfahrensanspruchs 1 und des zugehörigen Vorrichtungsanspruchs 6 dadurch gelöst, dass das Optimierungsproblem der modellprädiktiven Regelung in zwei Optimierungsprobleme aufgeteilt wird, indem in der Steuereinheit ein modellprädiktiver Ausgangsgrößenreglerund ein modellprädiktiver Drosselstromregler implementiert werden, wobei für den Ausgangsgrößenregler die Stränge des mehrphasigen DC/DC-Wandlers zu einem einzigen Strang zusammengefasst werden und daraus ein zeitdiskretes Zustandsraummodell erstellt wird und der Ausgangsgrößenregler anhand einer ersten Kostenfunktion des Optimierungsproblems des Ausgangsgrößenreglers die Eingangsspannung des nächsten Abtastschrittes für diesen einzigen Strang prädiziert, die dem Drosselstromregler als Vorgabe vorgegeben wird und der Drosselstromregler daraus anhand einer zweiten Kostenfunktion des Optimierungsproblems des Drosselstromreglers für den nächsten Abtastschritt die notwendigen Schalterstellungen der Schalter der Stränge des mehrphasigen DC/DC-Wandlers ermittelt. Durch die erfindungsgemäße Aufteilung des Reglers in zwei modellprädiktive, kaskadierte Unterregler, den Ausgangsgrößenregler und den Drosselstromregler, gelingt es, das Zustandsraummodell von einem Modell vierter Ordnung auf ein Modell zweiter Ordnung zu reduzieren. Das reduziert auch das finite control set der modellprädiktiven Regelung, wodurch sich der Lösungsraum für das Optimierungsproblem erheblich reduziert. Insbesondere auch deshalb, weil der Rechenaufwand für die Drosselstromregelung gegenüber dem Rechenaufwand der Ausgangsgrößenregelung vernachlässigt werden kann, da der Freiheitsgrad der Drosselstromregelung sehr stark reduziert ist. Lösungen des Optimierungsproblems können daher mit dem erfindungsgemäßen Ansatz rascher gefunden werden, was es ermöglicht, auch größere Prädiktionshorizonte mit hohen Abtastraten zu verwenden.

Der mögliche Lösungsraum des Optimierungsproblems kann noch weiter erheblich eingeschränkt werden, wenn der Lösungsraum in Form einer Menge von möglichen Lösungen des Optimierungsproblems des Ausgangsgrößenreglers im Vorfeld untersucht wird und Lösungen, die nicht auftreten können aus dem Lösungsraum ausgeschieden werden. Das kann vorteilhafterweise derart erfolgen, dass ein Simulationslauf mit einer vorgegebenen Kontrollsequenz der Ausgangsgröße durchgeführt wird und die dabei auftretenden Eingangsvektoren des DC/DC-Wandlers aufgezeichnet werden und aus den Eingangsvektoren die Eingangsspannung der Ausgangsgrößenregelung rekonstruiert wird und die auftretenden Sequenzen der Eingangsspannung als reduzierter Lösungsraum gespeichert werden.

Ebenso kann der mögliche Lösungsraum des Optimierungsproblems erheblich reduziert werden, wenn Lösungen des Optimierungsproblems des Ausgangsgrößenreglers als ganzzahlige Linearkombination von Basisfunktionen dargestellt werden, wobei die Basisfunktionen für die ersten Abtastschritte eine Breite eines Abtastschrittes haben und die Basisfunktionen für die folgenden Abtastschritte eine Breite eines ganzzahligen Vielfachen eines Abtastschrittes haben.

Eine weitere Beschränkung des Lösungsraumes kann erzielt werden, wenn die ganzzahligen Linearkombinationen der Beschränkung unterliegen, dass Lösungen von einem Abtastschritt zum nächsten Abtastschritt nicht mehr als Eins schalten dürfen.

Die gegenständliche Erfindung wird nachfolgend unter Bezugnahme auf die Figuren 1 bis 13 näher erläutert, die beispielhaft, schematisch und nicht einschränkend vorteilhafte Ausgestaltungen der Erfindung zeigen. Dabei zeigt

Fig.1 eine bekannte Testanordnung zum Testen einer Last mit einem Batterieemulator,
Fig.1a eine bekannte Testanordnung zum Testen einer Batteriemittels eines Batterietesters,
Fig.2 die bekannte Schaltung einer Leistungselektronik eines Batterieemulators,
Fig.2a die bekannte Schaltung einer Leistungselektronik eines Batterietesters,
Fig.3 ein vereinfachtes elektrisches Schaltbild eines DC/DC-Wandlers,
Fig.4 eine erfindungsgemäße modellprädiktive Regelung eines DC/DC-Wandlers,
Fig.5 ein elektrotechnisches Modell Ersatzschaltbild für die Ausgangsgrößenregelung des DC/DC-Wandlers,
Fig.6 ein elektrotechnisches Ersatzschaltbild für die Drosselstromregelung des DC/DC-Wandlers,
Fig.7 ein erfindungsgemäßes Regelschema eines Batterieemulators,
Fig.8 ein erfindungsgemäßes Regelschema eines Batterieemulators mit einem Beobachter,
Fig.9 die Darstellung der Lösungen des Optimierungsproblems als Suchbaum,
Fig.10b die Aktivierung der Schalter der Halbbrücke des DC/DC-Wandlers durch die Drosselstromregelung bei einem vorgegebenen Input (Fig.10a),
Fig.11 eine beispielhafte Kontrollsequenz für den DC/DC-Wandler und
Fig.12 und 13 ein erfindungsgemäßes Verfahren zur Lösungsraumreduktion des Optimierungsproblems.

Ausgangspunkt des erfindungsgemäßen Verfahrens ist das bekannte Modell des Batterieemulators 1 wie in Fig.2 gezeigt, bzw. das bekannte Modell des Batterietesters 7 wie in Fig.2a gezeigt. Der Glättungskondensator $C_0$ wird als hinreichend groß angenommen, womit die Dynamik des Gleichrichters 11 vernachlässigt und die Gleichspannung $V_0$ konstant angenommen werden kann. Streuinduktivitäten der Kabel und Spulen, Nichtlinearitäten und parasitäre Kapazitäten der Halbleiterschalter der Halbbrücken werden ebenfalls vernachlässigt, was für normale Betriebszustände zulässig ist. Die Schalter S1 und S2, S3 und S4, S5 und S6 der einzelnen Brückenzweige sind immer gegengleich geschaltet, also S1 geschlossen und S2 offen oder umgekehrt, usw., um einen Kurzschluss über den Glättungskondensator $C_0$ zu vermeiden. Durch entsprechende Schaltung der Schalter S1 bis S6 lassen sich positive und negative Ströme, also ein bidirektionaler DC/DC-Wandler 12, realisieren. Selbstverständlich gilt das nachfolgend ausgeführte auch für einen unidirektionalen DC/DC-Wandler, bei dem in jeder Halbbrücke ein Schalter durch eine Diode ersetzt werden kann.

Obwohl die Erfindung nachfolgend am Beispiel eines Batterieemulators 1 beschrieben wird, sei hier angemerkt, dass die Erfindung in gleicher Weise auch bei einem Batterietester 7 mit im Wesentlichen gleicher Schaltung (siehe Fig.2a) angewendet werden. Allfällige Unterschiede werden an der jeweiligen Stelle der nachfolgenden Beschreibung erläutert.

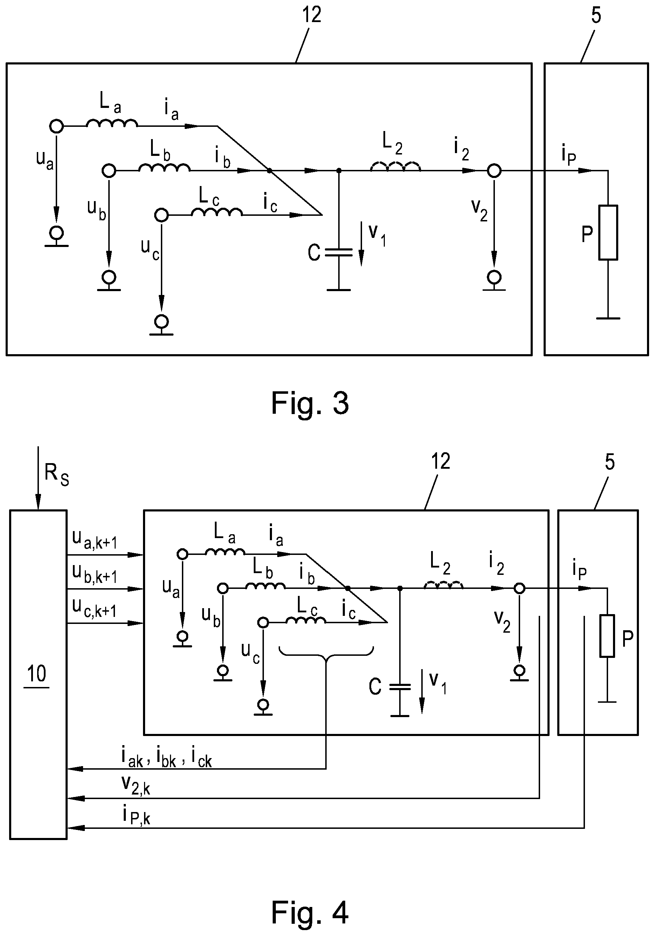

Diese Annahmen führen zum vereinfachten Modell des Batterieemulators 1 bzw. allgemein eines mehrphasigen DC/DC-Wandlers 12, wie in Fig.3 dargestellt, wobei in Fig.3 die ohmschen Widerstände $R_a$, $R_b$, $R_c$ der Drosseln $L_a$, $L_b$, $L_c$ der Einfachheit halber nicht dargestellt sind. Angedeutet ist in Fig.3 auch die häufig anzutreffende zusätzliche ausgangsseitige Drossel $L_2$ bei einem Batterietester 7.

Die Eingangsspannungen $u_a$, $u_b$, $u_c$ des mehrphasigen DC/DC-Wandlers 12 sind definiert durch $u_a = S_a V_0$, $u_b = S_b V_0$ und $u_c = S_c V_0$, wobei die Signale $S_a$, $S_b$, $S_c$ acht verschiedene Zustände annehmen können, gemäß der Tabelle 1. Damit ergeben sich acht mögliche Zustände für den Systemeingang, die das finite control set des Systems bilden.

Tabelle 1

| $S_a$ | $S_b$ | $S_c$ |
|---|---|---|
| 1 | 1 | 1 |
| 1 | 1 | 0 |
| 1 | 0 | 1 |
| 1 | 0 | 0 |
| 0 | 1 | 1 |
| 0 | 1 | 0 |

(fortgesetzt)

| $S_a$ | $S_b$ | $S_c$ |
|---|---|---|
| 0 | 0 | 1 |
| 0 | 0 | 0 |

Das Verhalten der Last 5 des DC/DC-Wandlers 12 wird als unbekannt angenommen, da das Regelverfahren für eine breite Palette möglicher Anwendungen des DC/DC-Wandlers 12 funktionieren soll. Als Last 5 wird daher eine Konstantleistungslast (CPL, constant power load) angenommen. Die Leistung P als Produkt aus Laststrom $i_P$ und Spannung $v_2$ am Eingang der Last ist konstant, $P = i_P \cdot v_2 = \text{const}$. Der Leistungsbedarf in Form der Leistung P wird durch die Last 5 vorgegeben. Die Abhängigkeit des Laststroms $i_P$ (=$i_2$) von der Ausgangsspannung $v_2$ stellt somit für das System eine Nichtlinearität dar.

Als Lastmodell kann auch eine ideale Spannungsquelle zum Einsatz kommen, insbesondere bei einem Batterietester 7, wobei auch ein Impedanzmodell, oder ein anderes Modell, der Batterie verwendet werden könnte.

Aus Fig.3 kann dann das Zustandsraummodell des DC/DC-Wandlers 12 mit Last 5 abgeleitet werden. Die Systemgleichungen ergeben sich aus der Anwendung der Kirchhoff'schen Gesetze, des Ohm'schen Gesetzes, sowie den Differentialgleichungen für einen idealen Kondensator und einer idealen Induktivität auf die Schaltung nach Fig.3 zu

$$\frac{di_a}{dt} = -\frac{R_a}{L_a}i_a - \frac{1}{L_a}v_2 + \frac{1}{L_a}u_a$$

$$\frac{di_b}{dt} = -\frac{R_b}{L_b}i_b - \frac{1}{L_b}v_2 + \frac{1}{L_b}u_b \quad .$$

$$\frac{di_c}{dt} = -\frac{R_c}{L_c}i_c - \frac{1}{L_c}v_2 + \frac{1}{L_c}u_c$$

$$\frac{du_C}{dt} = \frac{1}{C}\left(i_a + i_b + i_c - i_2\right)$$

Der nichtlineare Laststrom $i_P$ wird um eine aktuellen Betriebspunkt $P_0 = i_{P,0} \cdot v_{2,0}$ in der Form

$$i_P \approx i_{P,0} + \left.\frac{\partial}{\partial v_2}i_P\right|_0 \left(v_2 - v_{2,0}\right) = 2i_{P,0} - \underbrace{\frac{i_{P,0}}{v_{2,0}}}_{g_P}v_2$$ linearisiert. Das führt mit dem Zustandsraumvektor $\mathbf{x}_m = [i_a\, i_b\, i_c\, v_2]^T$,

dem Eingangsvektor $\mathbf{u}_m = [u_a\, u_b\, u_c]^T$ und dem Ausgangsvektor $\mathbf{y}_m$ mit $z_m = i_{p,0}$ zum zeitkontinuierlichen Zustandsraummodell

$$\dot{x}_m = \underbrace{\begin{bmatrix} -\dfrac{R_a}{L_a} & 0 & 0 & -\dfrac{1}{L_a} \\ 0 & -\dfrac{R_b}{L_b} & 0 & -\dfrac{1}{L_b} \\ 0 & 0 & -\dfrac{R_c}{L_c} & -\dfrac{1}{L_c} \\ \dfrac{1}{C} & \dfrac{1}{C} & \dfrac{1}{C} & -\dfrac{g_P}{C} \end{bmatrix}}_{A_m} x_m + \underbrace{\begin{bmatrix} \dfrac{1}{L_a} & 0 & 0 \\ 0 & \dfrac{1}{L_b} & 0 \\ 0 & 0 & \dfrac{1}{L_c} \\ 0 & 0 & 0 \end{bmatrix}}_{B_m} u_m + \underbrace{\begin{bmatrix} 0 \\ 0 \\ 0 \\ -\dfrac{2}{C} \end{bmatrix}}_{E_m} z_m \quad .$$

$$y_m = \underbrace{\begin{bmatrix} 0 & 0 & 0 & 1 \end{bmatrix}}_{C_m} x_m$$

Das zeitkontinuierliche Zustandsraummodell wird durch Diskretisieren mittels Zero-Order Hold (ZOH) mit der Abtastzeit $T_S$ in ein zeitdiskretes Zustandsraummodell (bezeichnet mit dem Subskript d) umgewandelt (was hinreichend bekannt ist) und gleichzeitig der Zustandsvektor um $z_m = i_{P,0}$ ergänzt. Der Zustandsvektor $\mathbf{x}_o$ ergibt sich dann zu $\mathbf{x}_o = [i_a\ i_b\ i_c\ v_2\ i_{P,0}]^T$ und das zeitdiskrete Zustandsraummodell mit dem Eingangsvektor $\mathbf{u}_o = [u_a\ u_b\ u_c]^T$ zu

$$x_{o,k+1} = \begin{bmatrix} A_{m,d} & E_{m,d} \\ 0 & 1 \end{bmatrix} x_{o,k} + \begin{bmatrix} B_{m,d} \\ 0 \end{bmatrix} u_{o,k}.$$

$$y_{o,k} = \begin{bmatrix} 0 & 0 & 0 & 1 & 0 \end{bmatrix} x_{o,k}$$

k bezeichnet dabei den jeweiligen Abtastschritt.

Bei Verwendung anderer Lastmodelle kann das zeitdiskrete Zustandsraummodell auch vom oben beschriebenen abweichen, ohne das Grundprinzip der Erfindung zu verändern. Insbesondere kann auch für den Batterietester 7 nach Fig.2a in analoger Weise ein zeitdiskretes Zustandsraummodell erstellt werden.

Für die modellprädiktive Regelung wird eine zu optimierende Kostenfunktion J benötigt. Für die Regelung eines DC/DC-Wandlers 12 wird hierfür eine Kostenfunktion aufgestellt, die bewertet, wie gut die Ausgangsspannung $v_2$, bzw. der Ausgangsstrom $i_2$, des DC/DC-Wandlers 12 einem vorgegebenen Referenzsignal $R_s$, z.B. in Form einer vorgegebenen Spannung $v_{PR}$ oder eines vorgegebenen Stromes $i_{PR}$, folgen kann. Die Kostenfunktion soll hierzu primär die Abweichung des Systemausgangs $\mathbf{Y}_o = [y_{o,k+1}\ y_{o,k+2} \cdots y_{o,k+Np}]^T$ vom Referenzsignal $R_s$ bewerten. Beim Batterieemulator 1 ist der Systemausgang $y_o$ die Ausgangsspannung $v_2$ und beim Batterietester 7 der Ausgangsstrom $i_2$. Mit $N_P$ ist der Prädiktionshorizont bezeichnet, der angibt, wieviel Zeitschritte k in die Zukunft gerechnet wird. Weiters sollen die Schaltverluste beim Schalten der Schalter S1 ... S6 bewertet werden. Ebenfalls ist es vorteilhaft, wenn darauf geachtet wird, dass die Strangströme $i_a$, $i_b$, $i_c$ des mehrphasigen DC/DC-Wandlers 12 möglichst gleich sind, um zu vermeiden, dass durch einzelne Stränge zu hohe Strangströme fließen, was die Hardware beschädigen könnte. Es wird daher eine Kostenfunktion J in der Form $J = (R_s - Y_o)^T (R_s - Y_o) + \lambda_s \cdot T^T T + \lambda_B \cdot \Delta C^2$ formuliert.

Darin bewertet der Term $(R_s - Y_o)^T (R_s - Y_o)$ die Abweichung des Systemausgangs $\mathbf{Y}_o$ vom Referenzsignal. Mit dem Term $\lambda_s \cdot T^T T$ werden die Schaltverluste bewertet, wobei $\mathbf{T} = [t_k\ t_{k+1} \ldots\ t_{k+Np-1}]^T$ mit $t_k = |u_{a,k} - u_{a,k-1}| + |u_{b,k} - u_{b,k-1}| + |u_{c,k} - u_{c,k-1}|$ die Häufigkeit der Schaltvorgänge der Schalter S1 ... S6 bewertet, in dem der Unterschied zwischen einer Eingangsgröße und der Eingangsgröße aus dem vorhergehenden Zeitschritt bestraft wird. Mit dem Gewichtungsfaktor $\lambda_s$, mit dem dieser Term in der Kostenfunktion J gewichtet wird, erhält man einen zusätzlichen Abstimmparameter für die Regelung. Mit dem Term $\lambda_B \cdot \Delta C^2$ wird die Abweichung der Strangströme zueinander bewertet, mit

$$\Delta C = \sum_{k=1}^{N_P} \max\left(i_{a,k}, i_{b,k}, i_{c,k}\right) - \min\left(i_{a,k}, i_{b,k}, i_{c,k}\right).$$ Damit wird die Abweichung zwischen dem maximalen Strangstrom und dem minimalen Strangstrom bestraft. $\lambda_B$ ist wieder ein Gewichtungsfaktor, der der Regelung einen zusätzlichen Abstimmparameter gibt. Alternativ könnte auch $\Delta C = \sum_{k=1}^{N_P} \left(i_{a,k} - i_{b,k}\right)^2 + \left(i_{b,k} - i_{c,k}\right)^2 + \left(i_{c,k} - i_{a,k}\right)^2$ verwendet werden.

Mit dem Gewichtungsfaktor $\lambda_s$ wird die Welligkeit der Ausgangsspannung $v_2$ bzw. des Ausgangsstromes $i_2$ und die Schaltfrequenz des Wandlers 12 beeinflusst. Je höher der Gewichtungsfaktor $\lambda_s$, umso größer wird die Welligkeit und umso geringer ist die Schaltfrequenz. Mit dem Gewichtungsfaktor $\lambda_B$ wird die Breite des Bandes beeinflusst innerhalb dem die Strangströme schwanken.

Es könnte natürlich auch ein Gewichtungsfaktor für den ersten Term in der obigen Kostenfunktion J angesetzt werden. Ebenso könnten in der Kostenfunktion auch andere oder zusätzliche Terme enthalten sein, um bestimmte andere oder weitere Aspekte zu bewerten.

Bei der modellprädiktiven Regelung können auch Randbedingungen berücksichtigt werden, was eine besondere Stärke der modellprädiktiven Regelung darstellt. Eine wichtige Randbedingung zum Schutz des Wandlers 12 und zur Verhinderung der Sättigung der Drosseln $L_a$, $L_b$, $L_c$ ist eine Limitierung der Strangströme $i_a$, $i_b$, $i_c$, z.B. in der Form $i_{min} \le i_a + i_b + i_c \le i_{max}$. Die Berücksichtigung der Randbedingung kann z.B. so erfolgen, dass eine Lösung der Kostenfunktion J auf den Wert unendlich gesetzt wird, wenn eine Randbedingung verletzt wird.

Diese Kostenfunktion J würde bei einer herkömmlichen modellprädiktiven Regelung nun für alle möglichen Kombinationen des Eingangsvektors $\mathbf{u}_o = [u_a\ u_b\ u_c]^T$ für den Prädiktionshorizont $N_P$ unter Berücksichtigung der Randbedingungen minimiert. Damit erhält man die Eingangsgrößen $\mathbf{u}_{o,k+1}$, $\mathbf{u}_{o,k+2}$, $\mathbf{u}_{o,k+Nc}$ für die nächsten Zeitschritte, wobei $N_C$ den Regelhorizont bezeichnet, der häufig gleich dem Prädiktionshorizonts $N_P$ ist. Nach dem Prinzip des zurückweichenden Horizonts (receding horizon) wird zu jedem Zeitpunkt nur der erste Regelvorgang $\mathbf{u}_{o,k+1}$ angewandt, und der Rest wird verworfen. Das wird für jeden Zeitschritt wiederholt. Dieses Grundprinzip einer modellprädiktiven Regelung ist hinlänglich bekannt, weshalb hier nicht näher darauf eingegangen wird.

Die modellprädiktive Regelung lässt sich wie in Fig.4 gezeigt darstellen. Die aktuellen Strangströme $i_{a,k}$, $i_{b,k}$, $i_{c,k}$, die aktuelle Ausgangsspannung $v_{2,k}$, bzw. der Ausgangsstrom $i_{2,k}$ bei einem Batterietester 7, und der aktuelle Laststrom $i_{P,k}$ werden gemessen und der Steuereinheit 10 zugeführt. Darin wird die Kostenfunktion J wie oben erläutert minimiert und aus dem ermittelten Eingangsvektor $\mathbf{u}_{o,k+1} = [u_{a,k+1}\ u_{b,k+1}\ u_{c,k+1}]^T$ ergeben sich unmittelbar die erforderlichen Schalterstellungen der Schalter S1 ... S6, die dann im nächsten Zeitschritt entsprechend geschaltet werden.

Wie eingangs bereits ausgeführt, müssen aber für die Optimierung der Kostenfunktion J sehr viele mögliche Kombinationen aufeinander folgender Eingangsvektoren $\mathbf{u}_{o,k}$ gerechnet werden, was sehr viel Rechenzeit in Anspruch nimmt. Im vorliegenden Beispiel käme man bei einem Prädiktionshorizonts $N_P$=10 auf $8^{10}$= 1.073.741.824 Kombinationsmöglichkeiten. Durch das nachfolgend beschriebene erfindungsgemäße Verfahren soll die Anzahl der Kombinationsmöglichkeiten deutlich reduziert werden.

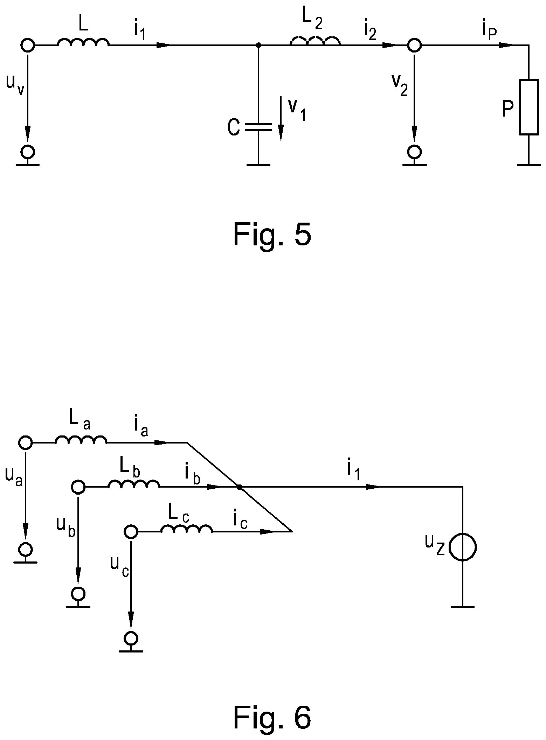

Hierzu wird die Regelung des DC/DC-Wandlers 12 in eine Ausgangsgrößenregelung, also eine Spannungsregelung der Ausgangsspannung $u_2$ bei einem Batterieemulator 1 (Fig.5) oder einer Stromregelung des Ausgangsstromes $i_2$ bei einem Batterietester 7, und eine Drosselstromregelung (Fig.6) aufgeteilt.

Für die Ausgangsgrößenregelung werden die Induktivitäten der Drosseln $L_a$, $L_b$, $L_c$ der einzelnen Stränge des DC/DC-Wandlers 12 zu einer Induktivität $L = L_a/3 = L_b/3 = L_c/3$ (unter der zulässigen Annahme gleicher Drosseln) zusammengefasst (Fig.5). Der Strom $i_1$ ergibt sich als Summe der einzelnen Drosselströme, $i_1 = i_a + i_b + i_c$. Gleichfalls werden die einzelnen (nicht dargestellten) Widerstände $R_a$, $R_b$, $R_c$ zu einem Widerstand $R = R_a/3 = R_b/3 = R_c/3$ (unter der zulässigen Annahme gleicher Widerstände) zusammengefasst. Damit wird das Modell vierter Ordnung der Fig.3 auf ein Modell zweiter Ordnung nach Fig.5 reduziert und gleichzeitig werden auch die möglichen Eingänge gemäß den möglichen Schalterstellungen auf die Eingangsspannung der Ausgangsgrößenregelung $u_v = \{0, V_0/3, 2V_0/3, V_0\}$ beschränkt. Damit besteht das finite control set der Ausgangsgrößenregelung nur aus vier Elementen. Analog wie zu Fig.3 beschrieben erhält man wieder das zeitdiskrete Zustandsraummodell in der Form

$$x_{v,k+1} = \underbrace{\begin{bmatrix} A_{U,d} & E_{U,d} \\ 0 & 1 \end{bmatrix}}_{Av} x_{v,k} + \underbrace{\begin{bmatrix} B_{U,d} \\ 0 \end{bmatrix}}_{Bv} u_v$$

$$y_v = \underbrace{\begin{bmatrix} 0 & 1 & 0 \end{bmatrix}}_{C_v} x_v$$

mit dem Zustandsvektor $\mathbf{x}_v = [i_1\ v_2\ i_{P,0}]^T$. Hierfür wird eine Kostenfunktion $J_v$ aufgestellt, in der wieder die Abweichung des Systemausgangs von einem Referenzsignal $R_s$ und die Schalthäufigkeit bewertet wird. Ein Term $(R_s-Y_v)^T(R_s-Y_v)$, mit $\mathbf{Y}_v = [y_{v,k+1}\ y_{v,k+2} \cdots y_{v,k+Np}]^T$, bewertet die Abweichung und ein Term $\lambda_v \cdot (T_{v,k}-T_{v,k-1})^T(T_{v,k}-T_{v,k-1})$, mit $\mathbf{T}_{v,k} = [u_{v,k}\ u_{v,k+1} \cdots u_{v,k+Np-1}]^T$, bestraft die Änderung zweier zeitlich aufeinander folgender Eingangsgrößen (Eingangsspannung $u_v$ der Ausgangsgrößenregelung), wobei der Gewichtungsfaktor $\lambda_v$ wieder ein Abstimmparameter für die Regelung ist. Die Kostenfunktion ergibt sich dann zu $J_v = (R_s-Y_v)^T(R_s-Y_v) + \lambda_v \cdot (T_{v,k}-T_{v,k-1})^T(T_{v,k}-T_{v,k-1})$. Die Randbedingung ergibt sich analog zu oben zu $i_{min} \le i_1 \le i_{max}$.

Bei einem Batterietester 7 mit Stromregelung wäre der Zustandsvektor $\mathbf{x}_v = [i_1\ v_1\ i_2\ v_2]^T$ und man erhält in analoger Weise ebenfalls ein zeitdiskretes Zustandsraummodell und eine Kostenfunktion $J_v$.

Da das finite control set für die Ausgangsgrößenregelung nur aus vier Elementen besteht, ergeben sich für die Lösung des Optimierungsproblems nur mehr $4^{Np}$ Kombinationsmöglichkeiten. Bei einem Prädiktionshorizonts $N_P$=10 ergeben sich damit nur mehr $4^{10}$= 1.048.576, also gegenüber Fig.3 um einen Faktor 1.000 weniger, Kombinationsmöglichkeiten.

Die Drosselstromregelung nach Fig.6 liefert unter Anderem die Zustandsgröße $i_1 = i_a + i_b + i_c$, die die Ausgangsgrößenregelung benötigt. Analog zu oben mit Bezugnahme auf Fig.3 beschrieben sollen die einzelnen Strangströme $i_a$,

$i_b$, $i_c$ dabei wieder innerhalb eines engen Bandes gehalten werden und es sollen zu große Abweichungen zwischen den einzelnen Strangströmen vermieden werden. Das Systemmodell der Drosselstromregelung kann daher, wie in Fig.6 gezeigt, durch die drei Stränge des DC/DC-Wandlers 12 und einer idealen Spannungsquelle $u_Z$ gebildet werden. Der Verlauf der übrigen Zustandsgrößen wird bereits von der Ausgangsgrößenregelung vorhergesagt. Deshalb wird in jedem Abtastschritt k die vorhergesagte Spannung am Kondensator C der idealen Spannungsquelle $u_Z$ zugewiesen, also $u_Z = v_2$.

Mit dem Zustandsvektor $\mathbf{x}_i = [i_a\ i_b\ i_c\ u_Z]^T$ und dem Eingangsvektor $\mathbf{u}_i = [u_a\ u_b\ u_c]^T$ ergibt sich das zeitkontinuierliche Zustandsraummodell der Drosselstromregelung nach Fig.6 zu

$$\dot{x}_i = \underbrace{\begin{bmatrix} -\dfrac{R_a}{L_a} & 0 & 0 & -\dfrac{1}{L_a} \\[2mm] 0 & -\dfrac{R_b}{L_b} & 0 & -\dfrac{1}{L_b} \\[2mm] 0 & 0 & -\dfrac{R_c}{L_c} & -\dfrac{1}{L_c} \\[2mm] 0 & 0 & 0 & 0 \end{bmatrix}}_{A_i} x_i + \underbrace{\begin{bmatrix} \dfrac{1}{L_a} & 0 & 0 \\[2mm] 0 & \dfrac{1}{L_b} & 0 \\[2mm] 0 & 0 & \dfrac{1}{L_c} \\[2mm] 0 & 0 & 0 \end{bmatrix}}_{B_i} u_i .$$

$$y_i = \underbrace{\begin{bmatrix} 1 & 1 & 1 & 0 \end{bmatrix}}_{C_i} x_i$$

Das zeitkontinuierliche Zustandsraummodell wird wiederum diskretisiert. Damit die Vorgabe der Ausgangsgrößenregelung $i_1 = i_a + i_b + i_c$ eingehalten werden kann, muss die Bedingung $u_v = 1/3(u_a + u_b + u_c)$ erfüllt sein, wie nach einfacher Herleitung gezeigt werden kann. Dies ergibt sich aus der Voraussetzung $L = L_a/3 = L_b/3 = L_c/3$. Es wird analog zu Fig.3 eine Kostenfunktion $J_i$ aufgestellt, die die Schalthäufigkeit und die Gleichheit der Strangströme bewertet.

$$J_i = \lambda_i \cdot T^T T + \lambda_B \cdot \Delta C^2$$

Als Nebenbedingung gilt $\dfrac{1}{3}(u_{a,k} + u_{b,k} + u_{c,k}) = u_{v,k}$, wobei $u_{v,k}$ von der Ausgangsgrößenregelung als prädizierte Spannung des nächsten Abtastschrittes k+1 vorgegeben wird. Durch diese Nebenbedingung liefert der Drosselstromregler immer den angeforderten Strom.

Die Drosselstromregelung bekommt die prädizierte nächste Eingangsspannung $u_{v,k+1}$ der Ausgangsgrößenregelung als Vorgabe und errechnet sich aus dieser Vorgabe den tatsächlichen Input auf das System in Form des Eingangsvektors $\mathbf{u}_i = [u_a\ u_b\ u_c]^T$ aus. Die Drosselstromregelung ermittelt damit die Schalterstellungen der Schalter S1 ... S6 für den nächsten Abtastschritt k+1. Für die unterlagerte Drosselstromregelung reicht ein Prädiktionshorizont $N_P$ von 1 aus. Die Drosselstromregelung muss aber dem Ausgangsgrößenregelung folgen, d.h. wenn letzterer 0 oder $3 \cdot V_0/3$ ausgibt, muss die Drosselstromregelung [0 0 0] bzw. [1 1 1] ausgeben. Dies ergibt für den Fall $1 \cdot V_0/3$ oder $2 \cdot V_0/3$ maximal drei übrigbleibende Möglichkeiten (z.B. für $2 \cdot V_0/3$ [1 1 0], [0 1 1] und [1 0 1]). Somit ist der Freiheitsgrad der Drosselstromregelung festgelegt. Die Drosselstromregelung teilt die Vorgabe der Ausgangsgrößenregelung auf die Stränge des mehrphasigen DC/DC-Wandlers 12 auf.

Durch die Lösung des Optimierungsproblems mit der Kostenfunktion $J_i$ wird innerhalb des Freiheitsgrads der Drosselstromregelung der optimale Spannungsvektor $\mathbf{u}_{i,k}$ ermittelt, der unmittelbar die Schalterstellungen der Schalter S1 ... S6 des mehrphasigen DC/DC-Wandlers 12 liefert. Falls alle oder kein Strang des mehrphasigen DC/DC-Wandlers 12 geschaltet ist, ist keine Optimierung notwendig und es wird $\mathbf{u}_i = [V_0\ V_0\ V_0]$ oder $\mathbf{u}_i = [0\ 0\ 0]$ angelegt. Ist nur ein oder sind zwei der Stränge geschaltet, dann ergeben sich jeweils drei verschiedene mögliche Schaltkombinationen. Beispielsweise für den Fall eines geschalteten Stranges folglich $\mathbf{u}_i = [V_0\ 0\ 0]$, $\mathbf{u}_i = [0\ V_0\ 0]$ oder $\mathbf{u}_i = [0\ 0\ V_0]$.

Der Vorteil ergibt sich nun daraus, dass das Optimierungsproblem auf zwei separate Optimierungsprobleme aufgeteilt wird, wobei das Optimierungsproblem der Drosselstromregelung für die Performance zu vernachlässigen ist. In Simulationen wurde festgestellt, dass für jeden beliebigen Prädiktionshorizont $N_P$ der Ausgangsgrößenregelung, ein Prädiktionshorizont $N_P = 1$ der Drosselstromregelung ausreicht. Das bedeutet, dass für die gesuchte Lösung des Optimierungsproblems der Drosselstromregelung maximal drei Kombinationsmöglichkeiten untersucht werden müssen.

Damit kann der Rechenaufwand für die Drosselstromregelung gegenüber dem Rechenaufwand der Ausgangsgrößenregelung vernachlässigt werden. Für die Lösung des Optimierungsproblems für die Ausgangsgrößenregelung und die Drosselstromregelung ergeben sich damit nur mehr $4^{Np}$ Kombinationsmöglichkeiten.

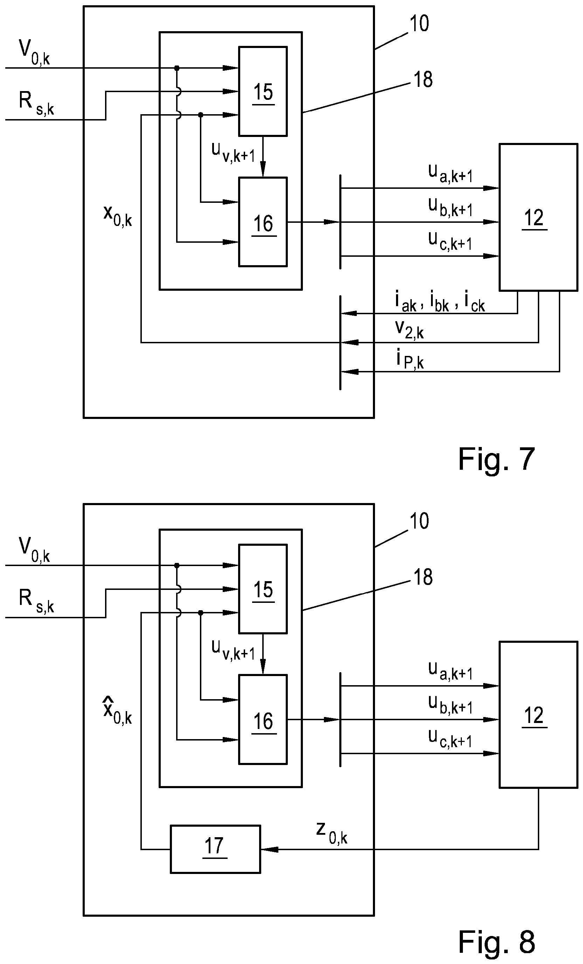

In Fig.7 ist das sich ergebende Regelschema anhand des Beispiels eines Batterieemulators 1 als Blockschaltbild dargestellt. In der Steuereinheit 10 ist der Regler 18 mit dem Ausgangsgrößenregler 15 für die Ausgangsgrößenregelung 15 und dem Drosselstromregler 16 für die Drosselstromregelung implementiert. Der Ausgangsgrößenregler 15 erhält als Eingang die Gleichspannung $V_0$ und das Referenzsignal $R_s$, dem der DC/DC-Wandler 12 am Ausgang folgen soll. Die aktuellen Zustandsgrößen $\mathbf{x}_{o,k}$, also Strangströme $i_{a,k}$, $i_{b,k}$, $i_{c,k}$, Ausgangsspannung $v_{2,k}$ und Laststrom $i_{P,k}$, werden gemessen und der Steuereinheit 10 zugeführt. Daraus werden die für den nächsten Abtastschritt k+1 anzulegenden Eingangsspannungen $u_{a,k+1}$, $u_{b,k+1}$, $u_{c,k+1}$, bzw. die Schalterstellungen der Schalter S1 ... S6, bestimmt und an den DC/DC-Wandler 12 angelegt.

Wenn der Zustandsvektor $\mathbf{x}$ gar nicht oder nur teilweise gemessen werden kann, dann könnte auch ein regelungstechnischer Beobachter 17, z.B. in Form eines Kalman Filters, implementiert werden, um aus gemessenen Größen $\mathbf{z}_{o,k}$ den benötigten Zustandsvektor $\hat{x}_{o,k}$ zu schätzen, wie in Fig.8 dargestellt. Nachdem solche Beobachter und deren Auslegung hinlänglich bekannt sind, wird das hier nicht näher erläutert.

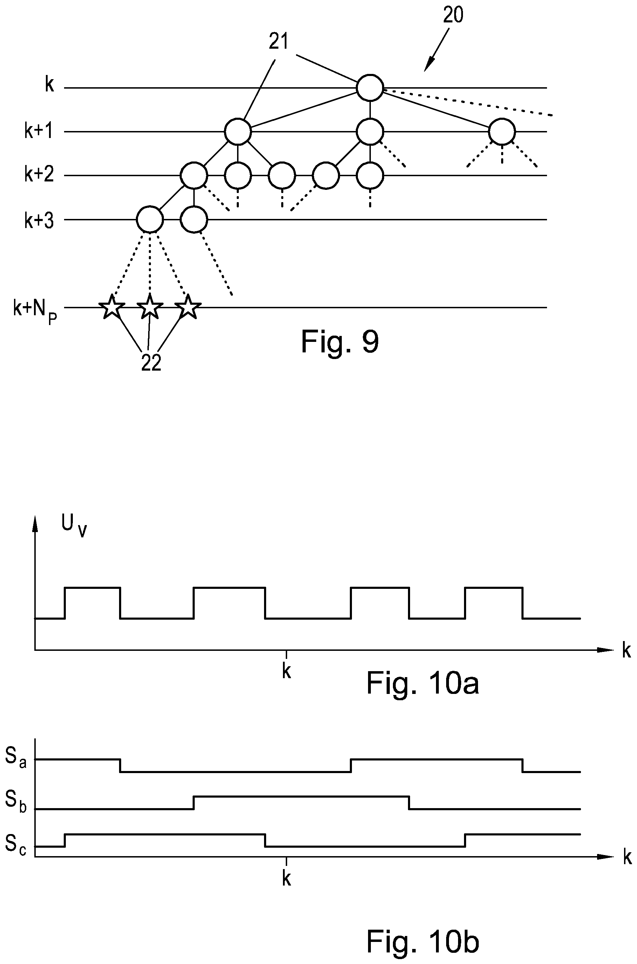

Die Lösungen des Optimierungsproblems kann man auch als Suchbaum 20 mit Knoten 21 und Blättern 22 und mit einer dem Prädiktionshorizont $N_p$ entsprechenden Tiefe darstellen, wie in Fig.9 gezeigt. Jedes Blatt 22 des Suchbaumes 20 stellt eine Lösung des Optimierungsproblems dar. Der Suchbaum 20 kann nun vollständig durchsucht werden, um das Optimierungsproblem zu lösen. Es können aber auch Baumsuchalgorithmen verwendet werden, um die Lösung des Optimierungsproblems schneller zu erhalten. Ein möglicher Algorithmus wäre z.B. wäre z.B. ein hinlänglich bekannter Branch & Bound Algorithmus. Damit wird die Menge der möglichen Lösungen in Teilmengen unterteilt und suboptimale Lösungen werden mittels Schranken erkannt und ausgesondert. Im schlechtesten Fall landet man auch hier bei einer vollständigen Durchsuchung des Suchbaumes 20. Nachdem der Algorithmus hinlänglich bekannt ist, wird hier auf eine nähere Beschreibung verzichtet.

Um die Anzahl der möglichen Lösungen von $4^{Np}$ nun noch weiter zu reduzieren, kann man auch versuchen, schon vor dem Durchsuchen des Suchbaumes 20 den möglichen Lösungsraum (also die Blätter 22 des Suchbaumes 20) zu reduzieren. Hier kann man die Kenntnis des zugrunde liegenden Optimierungsproblems ausnutzen.

Die große Mehrheit der möglichen Lösungen des Optimierungsproblems wird gar nie verwendet. Dies liegt daran, dass der Regler in der Steuereinheit 10 in den Kostenfunktionen $J_i$ und $J_v$ das Schalten zwischen Zuständen bestraft, um die Schaltfrequenz niedrig zu halten. Dadurch bewirkt der Regler in der Steuereinheit 10 nicht zu jedem Zeitpunkt einen Schaltvorgang der Schalter S1 bis S6. Dadurch ergeben sich aber Möglichkeiten, die Anzahl möglichen Lösungen, den Lösungsraum, zu beschränken.

Durch die Bestrafung von Schaltvorgängen in den Kostenfunktionen, kann das resultierende Inputsignal im stationären Betrieb aussehen wie z.B. in Fig.10 dargestellt. Fig.10 a) zeigt was die Ausgangsgrößenregelung vorgibt und Fig.10 b), wie die Drosselstromregelung dazu passend die Schalter S1 ... S6 aktiviert bzw. deaktiviert. Wenn man nun in einem ersten Verfahren zur Lösungsraumreduktion (im weiteren PP (principle pattern) genannt) für einen beliebigen Zeitpunkt k einen Snapshot von den darauffolgenden $N_P$ (Prädiktionshorizont) Abtastschritten k+$N_P$ macht, und für alle weiteren Zeitpunkte dasselbe macht, erkennt man, dass die Zahl der auftretenden unterschiedlichen Sequenzen der Eingangsspannung $u_v$ der Ausgangsgrößenregelung viel geringer ist als die $4^{NP}$ Möglichkeiten. Diese Sequenzen können gespeichert und zusammengefasst werden und der Steuereinheit 10 als reduzierter Lösungsraum (Suchbaum 20 mit weniger Blättern 22) vorgegeben werden. Somit wird die Anzahl möglicher Lösungen stark eingeschränkt. Die oben genannten Baumsuchalgorithmen haben dadurch nur noch einen viel kleineren, recht zerrütteten Suchbaum 20 zu durchsuchen. Hier werden am besten alle verbliebenen Blätter 22 des Suchbaumes 20 durchsucht, weil der Branch&Bound Algorithmus zu lange für die Vorbereitung benötigen würde (Overhead).

Das Gleiche gilt für einen Batterietester 7 mit dem Ausgangsstrom $i_2$ als Ausgangsgröße analog.

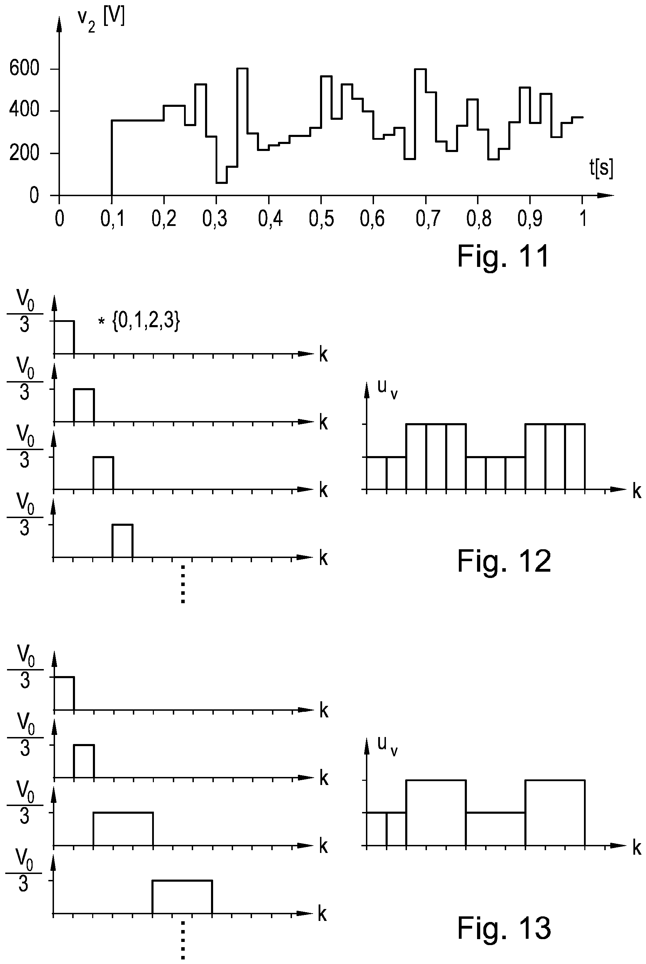

Um nun zu diesen Sequenzen zu gelangen, kann ein Simulationslauf mit einer Kontrollsequenz der Ausgangsgröße (Ausgangsspannung $v_2$ beim Batterieemulator 1, wie in Fig.11, oder Ausgangsstrom $i_2$ beim Batterietester 7) durchgeführt werden, die im Wesentlichen alle relevanten Betriebspunkte des DC/DC-Wandlers 12 abbildet. Eine solche Kontrollsequenz ist beispielhaft in Fig.11 dargestellt. Die dabei auftretenden Eingangsvektoren $\mathbf{u}_i = [u_a \, u_b \, u_c]^T$ des DC/DC-Wandlers 12 werden aufgezeichnet und der Eingang $u_v$ der Ausgangsgrößenregelung daraus rekonstruiert. Damit können diese Sequenzen extrahiert werden.

Ein zweites Verfahren zur Lösungsraumreduktion (im weiteren CBF (constraint basis functions) genannt) basiert auf einer Zerlegung des Lösungsraums. Der gesamte Lösungsraum der bisher betrachtet wurde, hat eine Basis wie in Fig.12 dargestellt, oder anders ausgedrückt $u_v = \dfrac{V_0}{3} u_{\text{int}}$ mit $u_{\text{int}} = \{0,1,2,3\}$. Jede Lösung stellt eine ganzzahlige Linearkombination dieser Basisfunktionen dar. Da der Regler in der Steuereinheit 10 typischerweise nicht zu jedem Abtastschritt k schaltet, siehe z.B. Fig.10, kann man auch eine andere Basis wählen, wie z.B. in Fig.13 dargestellt. Der Regler in der Steuereinheit 10 hat für die ersten zwei Abtastschritte volle Freiheit und wird nachher in der Zeit gröber aufgelöst, hier in Form von Basisfunktionen mit einer Breite von drei Abtastschritten. Der Lösungsraum beschränkt sich jetzt auf die ganzzahlige Linearkombination dieser Basisfunktionen.

Selbstverständlich können auch andere Basisfunktionen als die dargestellten verwendet werden, solange damit der Lösungsraum verkleinert wird. Beispielsweise wäre es denkbar, für noch größere Prädiktionshorizonte die zeitliche Auflösung noch gröber zu machen Weiters kann noch die Beschränkung eingeführt werden, dass die Lösungen von einem Abtastschritt zum nächsten nicht mehr als Eins schalten darf, z.B. $1 \cdot V_0/3$ zu $2 \cdot V_0/3$, aber nicht auf $3 \cdot V_0/3$. Dies führt zu einer weiteren Reduktion des Lösungsraums um mehrere Größenordnungen. Für die Implementierung können alle diese Lösungen vorberechnet werden und der Steuereinheit 10 als möglicher Lösungsraum zur Verfugung gestellt werden. Dazu werden offline alle möglichen ganzzahligen Linearkombinationen ausgewertet und jene ausgeschlossen, die obige Einschränkung verletzen. Die verbleibenden Linearkombinationen stehen dann dem Online-Algorithmus als reduzierter Suchraum zur Verfügung. Dieser reduzierte Lösungsraum kann nun einem Baumsuchalgorithmus übergeben werden, um den reduzierten Suchbaum 20 möglichst effektiv zu durchsuchen. Aufgrund der Struktur des sich ergebenden Suchbaumes 20 eignet sich hier der Branch & BoundAlgorithmus sehr gut.

Das Gleiche gilt analog für einen Batterietester 7 mit dem Ausgangsstrom $i_2$ als Ausgangsgröße.

In Tabelle 2 ist die Wirkung der oben beschriebenen Verfahren der Reduktion des Lösungsraumes des Optimierungsproblems dargestellt. Daraus erkennt man, dass die Anzahl der möglichen Lösungen für das Optimierungsproblem mit den obigen Methoden massiv reduziert werden können, was es ermöglicht auch große Prädiktionshorizonte $N_P$ in Echtzeit berechnen zu können.

Tabelle 2

| $N_P$ | $8^{N_P}$ | $4^{N_P}$ | PP | CBF |
|---|---|---|---|---|
| 1 | 8 | 4 | 4 | 4 |
| 2 | 64 | 16 | 14 | 10 |
| 3 | 512 | 64 | 33 | 26 |
| 4 | 4.096 | 256 | 48 | 26 |
| 5 | 32.768 | 1.024 | 67 | 26 |
| 6 | 262.144 | 4.096 | 81 | 68 |
| 7 | 2.097.152 | 16.384 | 116 | 68 |
| 8 | 16.777.216 | 65.536 | 178 | 68 |
| 9 | 134.217.728 | 262.144 | 237 | 178 |
| 10 | 1.073.741.824 | 1.048.576 | 313 | 178 |
| 11 | 8.589.934.592 | 4.194.304 | 489 | 178 |

Das erfindungsgemäße Verfahren ermöglicht es, für den Regler 18 in der Steuereinheit 10 große Prädiktionshorizonte $N_P$ zu berücksichtigen, wodurch der Regler 18 besser auf transiente Vorgänge reagieren kann und solche Vorgänge schneller und mit weniger Überschwingen ausregeln kann. Das wird durch die ermöglichte höhere Abtastrate unterstützt.

Das erfindungsgemäße Verfahren ist anhand eines mehrphasigen DC/DC-Wandlers 12 mit drei Strängen beschrieben worden. Es ist aber selbstverständlich, dass das Verfahren auch auf einen DC/DC-Wandler 12 mit weniger oder mehr Strängen übertragen werden kann.

**Patentansprüche**

1. Verfahren zur modellprädiktiven Regelung eines mehrphasigen DC/DC-Wandlers (12) mit einer Halbbrücke mit zwei Schaltern (S1, S2, S3, S4, S5, S6) für jeden Strang des mehrphasigen DC/DC-Wandlers (12), wobei die Schalter (S1, S2, S3, S4, S5, S6) zur Erzeugung einer gewünschten Ausgangsgröße ($v_2$, $i_2$) von einer Steuereinheit (10) angesteuert werden, **dadurch gekennzeichnet, dass** das Optimierungsproblem der modellprädiktiven Regelung in zwei Optimierungsprobleme aufgeteilt wird, indem in der Steuereinheit (10) eine modellprädiktive Ausgangsgrößenregelung und eine modellprädiktive Drosselstromregelung implementiert werden, wobei für die Ausgangsgrößenregelung die Stränge des mehrphasigen DC/DC-Wandlers (12) zu einem einzigen Strang zusammengefasst werden und daraus ein zeitdiskretes Zustandsraummodell erstellt wird und die Ausgangsgrößenregelung anhand einer ersten Kostenfunktion ($J_v$) des Optimierungsproblems der Ausgangsgrößenregelung die Eingangsspannung ($u_{v,k+1}$) des nächsten Abtastschrittes (k+1) für diesen einzigen Strang prädiziert, die der Drosselstromregelung als Vorgabe vorgegeben wird und die Drosselstromregelung daraus anhand einer zweiten Kostenfunktion ($J_i$) des Optimierungsproblems der Drosselstromregelung für den nächsten Abtastschritt (k+1) die notwendigen Schalterstellungen der Schalter (S1, S2, S3, S4, S5, S6) der Stränge des mehrphasigen DC/DC-Wandlers (12) ermittelt.

2. Verfahren nach Anspruch 1, **dadurch gekennzeichnet, dass** ein Lösungsraum in Form einer Menge von möglichen Lösungen des Optimierungsproblems der Ausgangsgrößenregelung im Vorfeld untersucht wird und Lösungen, die nicht auftreten können aus dem Lösungsraum ausgeschieden werden, um den Lösungsraum zu verkleinern.

3. Verfahren nach Anspruch 2, **dadurch gekennzeichnet, dass** ein Simulationslauf mit einer vorgegebenen Kontrollsequenz der Ausgangsgröße ($v_2$, $i_2$) durchgeführt wird und die dabei auftretenden Eingangsvektoren ($\mathbf{u}_i$) des DC/DC-Wandlers (12) aufgezeichnet werden und aus den Eingangsvektoren ($\mathbf{u}_i$) die Eingangsspannungen ($u_v$) der Ausgangsgrößenregelung rekonstruiert werden und die auftretenden Sequenzen der Eingangsspannung ($u_v$) als reduzierter Lösungsraum gespeichert werden.

4. Verfahren nach Anspruch 1, **dadurch gekennzeichnet, dass** Lösungen des Optimierungsproblems der Ausgangsgrößenregelung als ganzzahlige Linearkombination von Basisfunktionen dargestellt werden, wobei die Basisfunktionen für die ersten n Abtastschritte (k+n) eine Breite eines Abtastschrittes (k) haben und die Basisfunktionen für die folgenden Abtastschritte (k+m), mit m>n, eine Breite eines ganzzahligen Vielfachen eines Abtastschrittes (k) haben.

5. Verfahren nach Anspruch 4, **dadurch gekennzeichnet, dass** die ganzzahligen Linearkombinationen der Beschränkung unterliegen, dass Lösungen von einem Abtastschritt (k) zum nächsten Abtastschritt (k+1) nicht mehr als Eins schalten dürfen.

6. Modellprädiktiver Regler eines mehrphasigen DC/DC-Wandlers (12) mit einer Halbbrücke mit zwei Schaltern (S1, S2, S3, S4, S5, S6) für jeden Strang des mehrphasigen DC/DC-Wandlers (12) und mit einer Steuereinheit (10), die die Schalter (S1, S2, S3, S4, S5, S6) zur Erzeugung einer gewünschten Ausgangsgröße ($v_2$, $i_2$) ansteuert, **dadurch gekennzeichnet, dass** im Regler (18) ein modellprädiktiver Ausgangsgrößenregler (15) und ein modellprädiktiver Drosselstromregler (16) vorgesehen sind, wobei für den Ausgangsgrößenregler (15) zur Erstellung eines zeitdiskreten Zustandsraummodells die Stränge des mehrphasigen DC/DC-Wandlers (12) zu einem einzigen Strang zusammengefasst sind und der Ausgangsgrößenregler (15) anhand einer ersten Kostenfunktion ($J_v$) des Optimierungsproblems des Ausgangsgrößenreglers (15) die Eingangsspannung ($u_{v,k+1}$) des nächsten Abtastschrittes (k+1) für diesen einzigen Strang prädiziert und der Drosselstromregler (16) aus der prädizierten Eingangsspannung ($u_{v,k+1}$) anhand einer zweiten Kostenfunktion ($J_i$) des Optimierungsproblems des Drosselstromreglers (16) für den nächsten Abtastschritt (k+1) die notwendigen Schalterstellungen der Schalter (S1, S2, S3, S4, S5, S6) der Stränge des mehrphasigen DC/DC-Wandlers (12) ermittelt **und dass** die Steuereinheit (10) dem DC/DC-Wandler (12) im nächsten Abtastschritt (k+1) die ermittelten Schalterstellungen vorgibt.

**Claims**

1. A method for model predictive control of a multiphase DC/DC converter (12) having a half-bridge having two switches (S1, S2, S3, S4, S5, S6) for each strand of the multiphase DC/DC converter (12), wherein the switches (S1, S2, S3, S4, S5, S6) are controlled by a control unit (10) in order to produce a desired output variable ($v_2$, $i_2$), **characterized in that:** the optimization problem of the model predictive control is divided into two optimization problems by a model predictive output variable control and a model predictive choke current control being implemented in the control unit (10), wherein: the strands of the multiphase DC/DC converter (12) for the output variable control are combined into a single strand; a time-discrete state space model is produced therefrom and the output variable control predicts the input voltage ($u_{v,k+1}$) of the next sampling step (k+1) for this single strand on the basis of a first cost function ($J_v$) of the optimization problem of the output variable control, said input voltage being given to the choke current control as a setpoint and the choke current control determining therefrom the necessary switch positions of the switches (S1, S2, S3, S4, S5, S6) of the strands of the multiphase DC/DC converter (12) for the next sampling step (k+1) on the basis of a second cost function ($J_i$) of the optimization problem of the choke current control.

2. The method according to claim 1, **characterized in that:** a solution space is investigated in advance in the form of an amount of possible solutions of the optimization problem of the output variable control, and solutions that cannot occur are eliminated from the solution space, in order to reduce the size of the solution space.

3. The method according to claim 2, **characterized in that:** a simulation is run with a predetermined control sequence of the output variable ($v_2$, $i_2$), the input vectors ($\mathbf{u}_i$) of the DC/DC converter (12) occurring thereby are recorded, the input voltages ($u_v$) of the output variable control are reconstructed from the input vectors ($\mathbf{u}_i$), and the occurring sequences of the input voltage ($u_v$) are saved as a reduced solution space.

4. The method according to claim 1, **characterized in that:** solutions of the optimization problem of the output variable control are represented as an integer linear combination of basic functions, wherein the basic functions for the first n sampling steps (k+n) have a width of one sampling step (k), and the basic functions for the subsequent sampling steps (k+m), where m >n, have a width of an integer multiple of one sampling step (k).

5. The method according to claim 4, **characterized in that:** the integer linear combinations are subject to the limitation that solutions may not switch by more than one from one sampling step (k) to the next sampling step (k+1).

6. A model predictive controller of a multiphase DC/DC converter (12) having a half-bridge having two switches (S1, S2, S3, S4, S5, S6) for each strand of the multiphase DC/DC converter (12), and having a control unit (10) that controls the switches (S1, S2, S3, S4, S5, S6) in order to produce a desired output variable ($v_2$, $i_2$),**characterized in that:** a model predictive output variable controller (15) and a model predictive choke current controller (16) are provided in the controller (18); wherein: the strands of the multiphase DC/DC converter (12) for the output variable controller (15) are combined into a single strand, in order to produce a time-discrete state space model; the output variable controller (15) predicts the input voltage ($u_{v,k+1}$) of the next sampling step (k+1) for this single strand on the basis of a first cost function ($J_v$) of the optimization problem of the output variable controller (15); and the choke current control (16) determines, from the predicted input voltage ($u_{v,k+1}$), the necessary switch positions of the switches (S1, S2, S3, S4, S5, S6) of the strands of the multiphase DC/DC converter (12) for the next sampling step (k+1) on the basis of a second cost function ($J_i$) of the optimization problem of the choke current controller (16); **and in that:** the control unit (10) sets the determined switch positions for the DC/DC converter (12) in the next sampling step (k+1).

**Revendications**

1. Procédé de régulation prédictive par modèle d'un transformateur continu/continu polyphasé (12) comprenant un demi-pont pourvu de deux commutateurs (S1, S2, S3, S4, S5, S6) pour chaque conducteur de phase du transformateur continu/continu polyphasé (12), les commutateurs (S1, S2, S3, S4, S5, S6) étant commandés par une unité de commande (10) pour générer une grandeur de sortie désirée ($v_2$, $i_2$), **caractérisé en ce que** le problème d'optimisation de la régulation prédictive par modèle est divisé en deux problèmes d'optimisation par mise en oeuvre , dans l'unité de commande (10), d'une régulation de grandeur de sortie prédictive par modèle et d'une régulation de courant restricteur prédictive par modèle, les conducteurs de phase du transformateur continu/continu polyphasé (12) étant rassemblés en un conducteur de phase unique pour la régulation de grandeur de sortie et un modèle d'espace d'états temporellement discret étant créé à partir de là et la régulation de grandeur de sortie prédisant, sur la base d'une première fonction de coût ($J_v$) du problème d'optimisation de la régulation de grandeur de sortie, la tension d'entrée ($u_{v,k+1}$) de l'étape d'analyse (k+1) suivante pour ce conducteur de phase unique, laquelle tension d'entrée est prescrite comme consigne à la régulation de courant restricteur, et la régulation de courant restricteur déterminant à partir là, sur la base d'une seconde fonction de coût ($J_i$) du problème d'optimisation, la régulation de courant restricteur pour la prochaine étape d'analyse (k+1) des positions nécessaires des commutateurs (S1, S2, S3, S4, S5, S6) des conducteur de phase du transformateur continu/continu polyphasé (12).

2. Procédé selon la revendication 1, **caractérisé en ce qu'**un espace de solutions se présentant sous la forme d'un ensemble de solutions possibles du problème d'optimisation de la régulation de grandeur de sortie est recherché à l'avance et des solutions, qui ne peuvent pas se produire, peuvent être éliminées de l'espace de solutions pour réduire l'espace de solutions.

3. Procédé selon la revendication 2, **caractérisé en ce qu'**un cycle de simulation est effectué avec une séquence de commande prédéterminée de la grandeur de sortie ($v_2$, $i_2$) et les vecteurs d'entrée ($u_i$), ainsi produits, du transformateur continu/continu (12) sont enregistrés et les tensions d'entrée ($u_v$) de la régulation de grandeur de sortie sont reconstituées à partir des vecteurs d'entrée ($u_i$) et les séquences produites dans la tension d'entrée ($u_v$) sont stockées

comme un espace de solutions réduit.

4. Procédé selon la revendication 1, **caractérisé en ce que** des solutions du problème d'optimisation de la régulation de grandeur de sortie sont représentées sous la forme d'une combinaison linéaire entière de fonctions de base, les fonctions de base pour les n premières étapes d'analyse (n+k) ayant une largeur d'une étape d'analyse (k) et les fonctions de base pour les étapes d'analyse suivantes (k+m), avec m > n, ayant une largeur d'un multiple entier d'une étape d'analyse (k).

5. Procédé selon la revendication 4, **caractérisé en ce que** les combinaisons linéaires entières sont soumises à la restriction selon laquelle des solutions ne peuvent pas commuter à plus de une d'une étape d'analyse (k) à l'étape d'analyse suivante (k+1).

6. Régulateur prédictif par modèle d'un transformateur continu/continu polyphasé (12) comprenant un demi-pont pourvu de deux commutateurs (S1, S2, S3, S4, S5, S6) pour chaque conducteur de phase du transformateur continu/continu polyphasé (12) et une unité de commande (10) qui commande les commutateurs (S1, S2, S3, S4, S5, S6) pour générer une grandeur de sortie désirée ($v_2$, $i_2$), **caractérisé en ce qu'**un régulateur de grandeur de sortie prédictif par modèle (15) et un régulateur de courant restricteur prédictif par modèle (16) sont prévus dans le régulateur (18), pour le régulateur de grandeur de sortie (15) les conducteurs de phase du transformateur continu/continu polyphasé (12) sont rassemblés en un conducteur de phase unique pour créer un modèle d'espace d'états temporellement discret, et le régulateur de grandeur de sortie (15) prédisant, sur la base d'une première fonction de coût ($J_v$) du problème d'optimisation du régulateur de grandeur de sortie (15), la tension d'entrée ($u_{v,k+1}$) de la prochaine étape d'analyse (k+1) pour ce conducteur de phase unique, et le régulateur de courant restricteur (16) déterminant à partir de la tension d'entrée ($u_{v,k+1}$) prédite, sur la base d'une seconde fonction de coût ($J_i$) du problème d'optimisation du régulateur de courant restricteur (16) pour la prochaine étape d'analyse (k+1), les positions nécessaires des commutateurs (S1, S2, S3, S4, S5, S6) des conducteurs de phase du transformateur continu/continu polyphasé (12) et **en ce que** l'unité de commande (10) prescrit au transformateur continu/continu (12), à l'étape d'analyse (k+1), les positions de commutation déterminées.

Fig. 1

(Stand der Technik)

Fig. 1a

(Stand der Technik)

Fig. 2

(Stand der Technik)

Fig. 2a

(Stand der Technik)

Fig. 3

Fig. 4

Fig. 5

Fig. 6

Fig. 7

Fig. 8

20

21

k

k+1

k+2

k+3

k+N_P

22

# Fig. 9

$U_V$

k

k

# Fig. 10a

$S_a$

$S_b$

$S_c$

k

k

# Fig. 10b

Fig. 11

Fig. 12

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070114985 A1
- WO 2014006200 A1
- EP 2528225 B1
- WO 2013174967 A1
- WO 2013174972 A1

**In der Beschreibung aufgeführte Nicht-Patentliteratur**

- **O. KÖNIG et al.** *Model Predictive Control of a Battery Emulator for Testing of Hybrid and Electric Powertrains*
- **J. RODRIGUEZ et al.** State of the art of finite control set model predictive control in power electronics. *Industrial Informatics, IEEE Transactions,* Mai 2013, vol. 9 (2), 1003-1016